# EUROPEAN PATENT SPECIFICATION

(11) **EP 2 200 072 B1**
(45) Date of publication and mention of the grant of the patent: **14.03.2018**
(21) Application number: 08836871.7
(22) Date of filing: 08.10.2008
(51) Int. Cl.: H01L 21/22, H01L 21/205, H01L 21/324, H01L 21/683, H01L 21/68, H01L 21/31

(54) **VERTICAL WAFER BOAT**
VERTIKALE WAFERHORDE
NACELLE DE TRANCHES VERTICALE

(30) Priority: 12.10.2007 JP 2007266479
(43) Date of publication of application: 23.06.2010
(73) Proprietor: CoorsTek KK, Tokyo 141-0032 (JP)
(72) Inventor: AOKI, Tatsuhiko, Kitakanbara-gun Niigata 957-0197 (JP); IZUNOME, Koji, Kitakanbara-gun Niigata 957-0197 (JP); ARAKI, Koji, Kitakanbara-gun Niigata 957-0197 (JP); INABA, Takeshi, Yamagata 999-1351 (JP); YAMAGUCHI, Toshihiro, Yamagata 999-1351 (JP); TABEI, Takahiro, Yamagata 999-1351 (JP); HADA, Takashi, Yamagata 999-1351 (JP); TANAKA, Tatsuya, Yamagata 999-1351 (JP); KAWAMURA, Takafumi, Hadano-shi Kanagawa 257-8566 (JP); KANEMARU, Eiichi, Hadano-shi Kanagawa 257-8566 (JP); SEKIGUCHI, Masayuki, Tokyo 141-0032 (JP)
(74) Representative: Hoffmann Eitle
(86) International application number: PCT/JP2008/068275
(87) International publication number: WO 2009/048068

(56) References cited:
- JP-A- 11 126 755
- JP-A- 11 126 755
- JP-A- 11 340 155
- JP-A- 11 340 155
- JP-A- 2001 168 175
- JP-A- 2004 119 538
- JP-A- 2006 080 452
- JP-A- 2006 080 452
- JP-A- 2007 266 156
- US-A1- 2005 145 584

## Description

### Technical Field

The present invention relates to a vertical wafer boat used for the heat treatment of a wafer, and more particularly to a vertical wafer boat having long wafer support portions.

### Background Art

A wafer used to manufacture a semiconductor device is subjected to a heat treatment, and the heat treatment is performed by accommodating a vertical wafer boat, on which a lot of wafers are placed, in a heat treatment apparatus.

Incidentally, as the diameter of a wafer is increased recently, since the wafer becomes liable to slip, a countermeasure for the slip is an important problem. As a countermeasure for suppressing slip, for example, Japanese Patent Application Laid-Open Publication No. 2006-080452 proposes an invention for suppressing occurrence of slip by minimizing deformation of a wafer by supporting the wafer support portions from the outer periphery of the wafer to the position of 40 to 60% of the radius thereof.

Document US 2005/0145584 A1 discloses a wafer boat with interference fit wafer supports, such supports being designed for supporting a batch of wafers while minimizing thermal stresses.

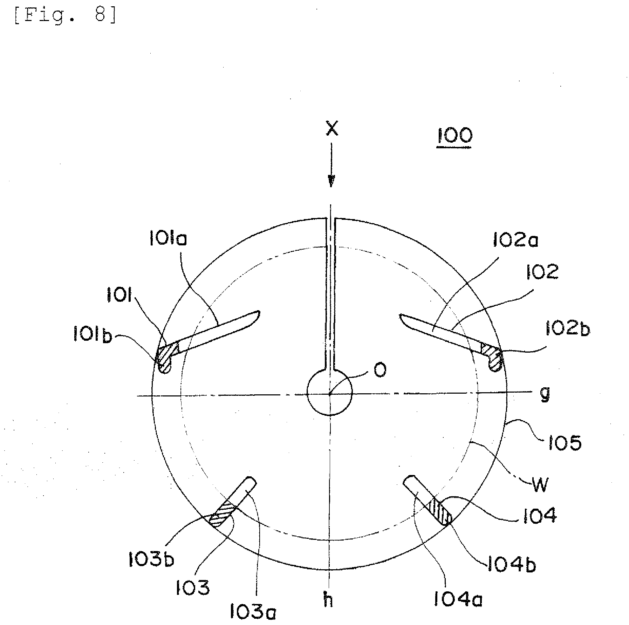

The proposed vertical wafer boat will be described based on Fig. 8. Note that Fig. 8 shows the vertical wafer boat when the wafer boat is observed from above it therethrough.

In Fig. 8, the wafer boat 100 has front support members 101 and 102, and rear support members 103 and 104 when viewed from a direction X in which a wafer is inserted, and these support members 101, 102, 103, and 104 are disposed in a vertical direction in parallel with each other. These support members 101, 102, 103, and 104 stand on a disk-shaped base (bottom plate), and further the upper ends of the respective support members are supported by disk-shaped upper fixed member (top plate).

Note that reference numeral 105, which shows an outer peripheral circle shown in Fig. 8, shows the upper fixed member (top plate) of the wafer boat 100. Further, a symbol W, which is shown by a virtual line, shows a position of a wafer mounted on the wafer boat 100. Further, an arrow X shows a direction in which the wafer W is inserted to the wafer boat 100.

The respective support members 101 to 104 are composed of support column portions 101b, 102b, 103b, and 104b and a plurality of wafer support portions 101a, 102a, 103a, and 104a which are formed to horizontally project from the side surfaces of the support column portions 101b, 102b, 103b, and 104b.

Further, the support members 101, and 102, which are positioned forward of the wafer insertion direction, and the support members 103, and 104, which are positioned rearward of the wafer insertion direction, are disposed symmetrically with respect to a virtual line h which passes through the center O of insertion of the wafer W and extends in the insertion direction X of the wafer W.

Further, the horizontal cross sections including the wafer support portions of the support members 101 and 102, which are positioned forward of the wafer insertion direction, are formed in an approximately flexure shape, whereas the wafer support portions 103a and 104a extend approximately linearly from the support members 103 and 104.

Here, the extreme ends, which face the wafer insertion center of the wafer support portions 101a and 102a, of the support members 101 and 102 positioned forward of the wafer insertion direction and the extreme ends of the support members 103 and 104 positioned forward of the wafer insertion direction are arranged to the position of 40 to 60% of the radius of the wafer W.

With this arrangement, since the wafer W is supported by the respective wafer support portions 101a, 102a, 103a, and 104a, the wafer W can be suppressed from being deformed. As a result, since stress concentration of the grooves on the wafer insertion sides to the positions forward of a wafer insertion side direction can be reduced, a slip reduction countermeasure can be employed effectively.

### Problems to be Solved by the Invention

Although the vertical wafer boat having the wafer support portions extending to the position of 40 to 60% of the radius of the wafer W described above, i.e., the vertical wafer boat having a so-called long wafer support portions is very effective to minimize deformation of a wafer, the wafer boat has a technical problem in that it cannot securely suppress occurrence of slip of the wafer.

Further, it is known that as a time passes after the vertical wafer boat begins to be used, metal impurities are deposited on (transferred) to the vertical wafer boat, and it becomes polluted. Accordingly, the vertical wafer boat is periodically subjected to a rinsing or purifying process.

The purifying process is performed by accommodating the vertical wafer boat, on which no wafer is mounted, in a heat treatment furnace and flowing a purifying gas thereto for a predetermined period of time to diffuse and remove the metal impurities from a surface layer of the vertical wafer boat.

However, when the vertical wafer boat having the long wafer support portions as described above is purified, since the distance between the wafer support portions disposed to the vertical wafer boat is narrow and further the wafer support portions are long, a technical problem arise in that the purifying process cannot be effectively performed in a short period of time because the purifying gas does not sufficiently reach the vicinities of support columns of the wafer support portions. In particular, the purifying gas is not substituted in a region where it stays, from which a technical problem arises in that the purifying process is insufficiently performed.

The inventors examined a vertical wafer boat having wafer support portions the length of which is increased not only from a viewpoint of suppression of wafer deformation but also from a viewpoint of minimization of generation of stress caused by the deformation and a viewpoint of a gas flow in the boat.

As a result, the inventors have conceived the present invention in that when an opening of a top plate of a vertical wafer boat has a particular shape and size and further wafer support portions have a specific disposition and structure, slip of a wafer can be securely suppressed and a purifying process can be effectively performed to the vicinities of support columns of the wafer support members the length of which is increased.

The present invention was made in view of the above circumstances.

US 2005/145584A1 discloses a wafer boat comprising a combination of features falling within the scope of the preamble of Claim 1. Further prior art is known from JP 11 126 755 A and JP 2007 266156A.

### Summary of the Invention

According to the present invention, there is provided a vertical wafer boat having a top plate, a plurality of support columns each having one end fixed to the top plate and the other end fixed to a bottom plate, and wafer support portions projecting from side surfaces of the support columns in a horizontal direction, wherein the top plate has an opening formed using the center point of a wafer to be mounted as its center and a slit portion communicating with the opening and formed to the insertion side of the wafer, and wherein the slit has a width which is 35% or more to 45% or less of the width of the top plate, the vertical wafer boat characterized in that: the wafer support portions extend to the position of 60% or more to 75% or less of the radius of the wafer from the center of the wafer to be mounted and, further, upper surface corners of the wafer support portions are chamfered up to the position of 40% or more to 60% or less of the length of the wafer support portions from the extreme ends of the wafer support portions toward the direction of the support columns as well as the upper surface corners of the wafer support portions from the positions at which the chamfering is ended to the support columns are formed at an angle of 90° or less.

It is preferable that the area of the opening of the top plate be 30% or more to 40% or less of the area of upper surface of the top plate and that the slit width of the top plate be the same as the interval between the extreme ends of the two wafer support portions positioned forward of a wafer insertion direction.

### Effect of the Invention

With embodiments of the present invention, there can be obtained a vertical wafer boat which can securely suppress slip of a wafer, by which the purifying efficiency of a purifying process is improved, and which has wafer support portions the length of which is increased.

### Brief Description of the Drawings

To enable a better understanding of the present invention, and to show how the same may be carried into effect, reference will now be made, by way of example only, to the accompanying drawings, in which:-
Fig. 1 is a front view of a vertical wafer boat according to an embodiment;
Fig. 2 is a side elevational view of the vertical wafer boat shown in Fig. 1;
Fig. 3 is a plan view of a top plate of the vertical wafer boat;
Fig. 4 is a sectional view taken along line I-I of Fig. 1;
Fig. 5 is a side elevational view of the support portion of the vertical wafer boat according to the embodiment;
Fig. 6 is a plan view of a support portion forward in a wafer insertion direction;
Fig. 7 is a plan view of a support portion rearward in the wafer insertion direction; and
Fig. 8 is a plan view showing a wafer support portion of a conventional vertical wafer boat.

### Detailed description

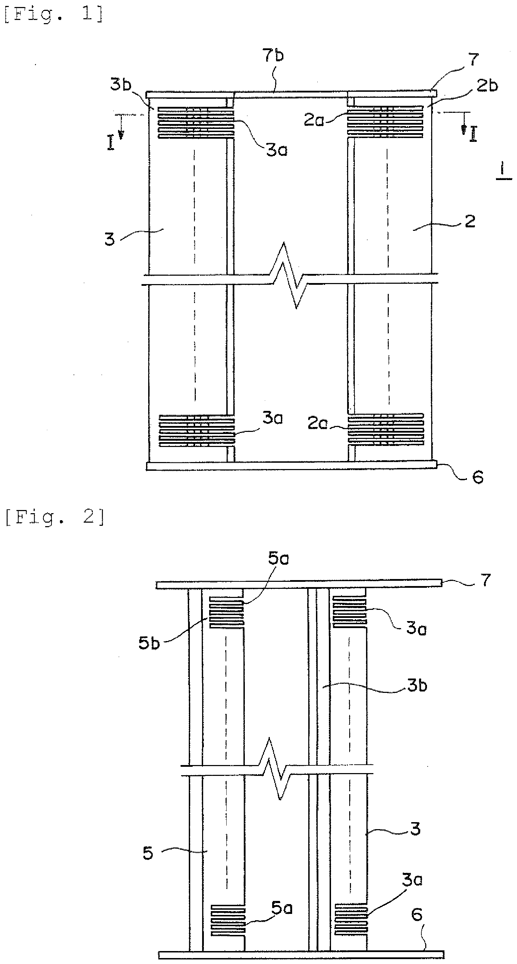

The vertical wafer boat according to an embodiment of the present invention is described below with reference to Figs. 1 to 7.

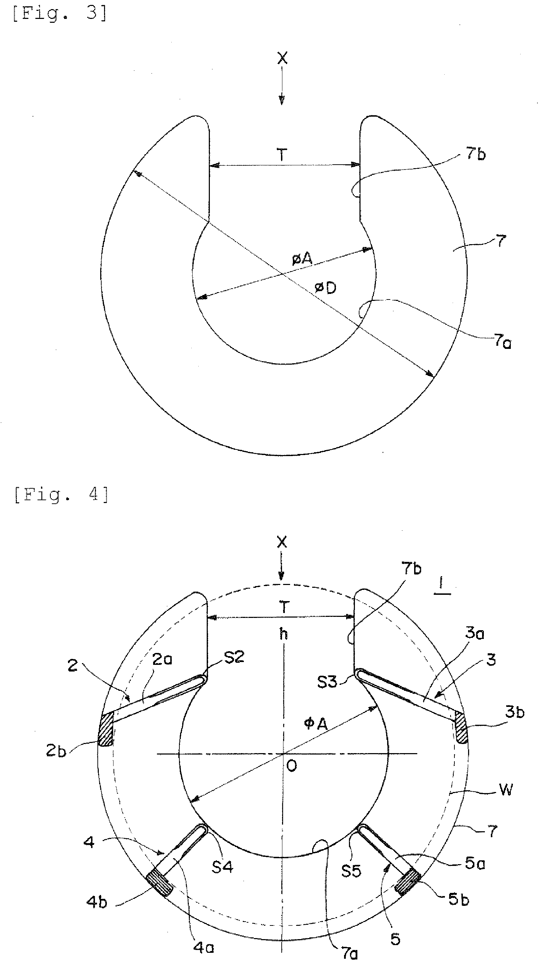

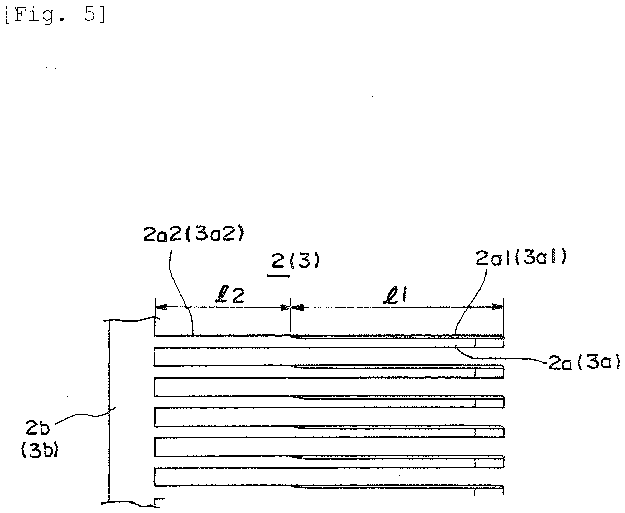

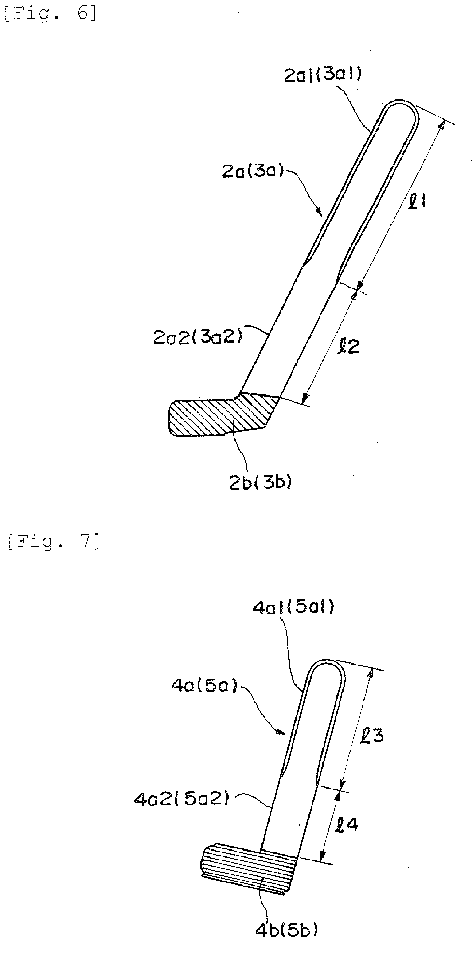

Fig. 1 is a front view of a vertical wafer boat according to an embodiment, Fig. 2 is a side elevational view of the vertical wafer boat shown in Fig. 1, Fig. 3 is a plan view of a top plate of the vertical wafer boat, Fig. 4 is a sectional view taken along line I-I of Fig. 1, Fig. 5 is a side elevational view of the support portion of the vertical wafer boat according to the embodiment, Fig. 6 is a plan view of a support portion forward in a wafer insertion direction, Fig. 7 is a plan view of a support portion rearward in the wafer insertion direction.

As shown in Figs. 1 and 2, a vertical wafer boat 1 has front support members 2, 3 and rear support members 4, 5 when viewed from a direction X in which a wafer is inserted, and these support members 2, 3, 4, and 5 are disposed in a vertical direction in parallel with each other. The lower ends of the respective support members 2, 3, 4, and 5 stand on a disk-shaped bottom plate 6, and further the upper ends of the respective support members 2, 3, 4, and 5 are supported by a disk-shaped top plate 7.

Further, arrangements of the respective support members 2, 3, 4, and 5 will be explained based on Fig. 4. Note that, likewise the case shown in Fig. 8, a symbol W shown by a virtual line of Fig. 4 shows a position of a wafer mounted on the vertical wafer boat 1, and an arrow X shows an insertion direction into which the wafer W is inserted into the vertical wafer boat 1.

The respective support members 2, 3, 4, and 5 are composed of support column portions 2b, 3b, 4b, and 5b and a plurality of wafer support portions 2a, 3a, 4a, and 5a which are formed so as to horizontally extend from the side surfaces of these support column portions 2b, 3b, 4b, and 5b, respectively, and the horizontal cross sections including the wafer support portions of the respective support members 2, 3, 4, and 5 are formed in an approximately flexure shape.

Further, as shown in Fig. 1, the wafer support portions 2a, 3a, 4a, and 5a in the respective support members 2, 3, 4, and 5 are formed in the number of 50 to 150 pieces in a vertical direction at a pitch of 8 mm.

Further, the support members 2 and 3, which are positioned forward of the wafer insertion direction, are formed line-symmetrically with respect to a virtual line h connecting the insertion direction X of the wafer W to an insertion center point O of the wafer W, and the extreme ends S2 and S3 of the wafer support portions 2a and 3a are formed in an semi-circular shape when viewed from above it.

Further, the support members 4 and 5, which are positioned rearward of wafer insertion direction, are formed line- symmetrically with respect to the virtual line h passing through the insertion center point O of the wafer W and extending in the insertion direction X of the wafer W.

Then, the support members 4 and 5, which are positioned rearward of the wafer insertion direction, are formed approximately linearly toward the insertion center point O of the wafer W, and the wafer support portions 4a and 5a extend straight from the support members 4 and 5 rearward of the wafer insertion direction. The extreme ends S4 and S5 of the wafer support portions 4a and 5a formed in a semi-circular shape when viewed from above it.

In the present invention, the extreme ends S2 and S3 of the wafer support portions 2a and 3a and the extreme ends S4 and S5 of the wafer support portions 4a and 5a are arranged such that they are disposed to the positions of 60% or more to 75% or less of the radius of the wafer W from the center of the wafer. Generation of stress can be minimized by disposing the extreme ends S2, S3, S4, and S5 to the predetermined positions, respectively with a result that occurrence of slip of the wafer can be reduced.

Note that, as described above, the positions of the extreme ends of the wafer support portions are optimum in the vertical wafer boat in which the four wafer support portions exist and more preferably located from 65% or more to 75% or less in the radius direction of the wafer from the center thereof.

Further, an opening 7a of the top plate 7 is formed at the center thereof to form a main flow of a gas at the center of the top plate 7 when purification is performed. The opening 7a is formed to have a diameter φA so that the extreme ends S2, S3, S4, and S5 of the wafer support portion 2, 3, 4, and 5 do not project inward of the opening 7a when viewed from the upper surface of the top plate 7. This arrangement is more preferable because it is possible to make it difficult for the extreme ends S2, S3, S4, and S5 of the wafer support portions 2, 3, 4, and 5 projecting in the opening 7a to cause abnormal gas disturbance on the central side of the wafer.

Although the opening 7a is preferably formed in a circular shape about the center of the top plate (center of the wafer to be placed), it is not particularly limited thereto and may be formed in other shapes, for example, polygonal shapes such as a square shape, a hexagonal shape, an octagon shape, and the like, an oval shape, a star shape, and a gear shape.

Further, the outside shape of the top plate 7 is preferably formed in a circular shape ordinarily, it is not particularly limited thereto and may be formed in other shapes, for example, polygonal shapes such as a square shape, a hexagonal shape, an octagonal shape, and the like, an oval shape, an approximately star shape, and a gear shape.

Further, a slit portion 7b communicating with the opening 7a is formed to the side of the top plate 7 from which the wafer W is inserted. The slit portion 7b is formed so that the intermediate point of the slit portion 7b in the width direction thereof is positioned on the virtual line h connecting the insertion direction X of the wafer W to the insertion center point O of the wafer W.

Further, the width T of the slit portion 7b of the top plate 7 is preferably set to a size of 35% or more to 45% or less of the width of the top plate. When the top plate 7 is formed in a rectangular shape, the width of the top plate 7 means the length thereof in the direction orthogonal to the wafer insertion direction X, and when the top plate 7 is formed in a circular shape, the width of the top plate 7 means the diameter φD of the top plate.

A reason why the width T of the slit portion 7b is set to 35% or more of the width of the top plate as described above resides in that when the width T of the top plate is less than 35%, a sufficient amount of a gas cannot be secured through the top plate 7. In contrast, a reason why the width T of the slit portion 7b is set 45% or less of the width of the top plate resides in that when the width T exceeds 45%, the strength of the boat is made weak and is not preferable.

Further, as shown in Figs. 5 and 6, the upper surface corners 2a1 and 3a1 of the wafer support portions 2a and 3a are chamfered up to a position of 40% or more to 60% or less of the length of the wafer support members 2 and 3 from the extreme ends of the wafer support portions 2a and 3a in a support column direction (in a length 11 of 40% or more to 60% or less of the length of the wafer support portions 2a and 3a).

Then, the upper surface corners 2a2 and 3a2 of the wafer support portions 2a and 3a are formed at an acute angle of 90° or less from the positions where the chamfering is ended to the support column portions 2b and 3b (in a length 12 of 40% or more to 60% or less of the length of the wafer support portions 2a and 3a).

Likewise, as shown in Fig. 7, the upper surface corners 4a1 and 5a1 of the wafer support portions 4a and 5a are chamfered up to a position of 40% or more to 60% or less of the length of the wafer support portions 4a and 5a from the extreme ends of the wafer support portions 4a and 5a in the support column direction (in a length 13 of 40% or more to 60% or less of the length of the wafer support portions 4a and 5a).

Then, the upper surface corners 4a2 and 5a2 of the wafer support portions 4a and 5a are formed at an acute angle of 90° or less from the positions where the chamfering is ended to the support column portions 4b and 5b (in a length 14 of 40% or more to 60% or less of the length of the wafer support portions 4a and 5a).

In the present invention, the chamfering of the wafer support portions 2a, 3a, 4a, and 5a is prescribed in view of the balance between suppression of occurrence of slip and the efficiency of generation of a gas turbulent flow generated in the vicinity of the support column portions 2b, 3b, 4b, and 5b of the wafer support portions 2a, 3a, 4a, and 5a.

That is, when the chamfering is performed from the extreme ends of the wafer support portions 2a, 3a, 4a, and 5a in the support column direction so as to have a length less than 40% of the length of them, a possibility of occurrence of slip is increased because a chance in which non-chamfered portions come into contact with the wafer W is increased.

In contrast, when the chamfering is performed from the extreme ends of the wafer support portions 2a, 3a, 4a, and 5a in the support column direction so as to have a length exceeding 60% of the length of them, it is difficult to obtain the efficiency of generation of the gas turbulent flow generated in the vicinity of the support column portions at the acute angle because the non-chamfered region is reduced (region having an acute angle of 90° or less is reduced). Note that the above chamfering includes C chamfering and R chamfering.

Further, the corners having the acute angle of 90° or less are formed to the upper surfaces of the wafer support portions 2a, 3a, 4a, and 5a from the positions where the chamfering is ended to the support column portions in order to generate a turbulent flow in the vicinity of the support column portions when the gas impinges against the corners.

When the corners of the upper surfaces of the wafer support portions 2a, 3a, 4a, and 5a have an angle exceeding 90°, the gas flows in a smaller amount in the corners and in particular it is difficult for a turbulent flow to occur in the vicinity of the support column portions, and thus this is not preferable.

Note that the sectional shape of the wafer support portions 2, 3, 4, and 5 is not particularly limited and may be a rectangular shape, a square shape, and a triangular shape, and the surfaces other than the upper surface may be a curved surface.

Further, in the present invention, the area of the opening 7a of the top plate 7 is preferably formed to have an area of 30% or more to 40% or less of the area of the upper surface of the top plate 7.

A reason why the area of the opening is prescribed as described above is to cause the gas to sufficiently flow to the wafer support portions 2a, 3a, 4a, and 5a located below the top plate 7.

Specifically, when the area of the opening 7a of the top plate 7 is less than 30% of the area of upper surface of the top plate, since it is difficult to sufficiently supply the gas to the lower portion of the boat, there is a possibility that a purifying effect cannot be sufficiently obtained. In contrast, when the area of the opening exceeds 40%, the flow of the gas which passes through the boat from above it to below it, is increased and the gas simply passes through inside of the boat without coming into contact with the support columns and the wafer support portions, there is also a possibility that the purifying effect cannot be sufficiently obtained.

Further, the width T of the slit portion 7b of the of the top plate 7 is more preferably the same as the interval between the extreme ends S2 and S3 of the support portions on the side where the wafer begins to be inserted.

In this case, since the edge of the slit portion 7b overlaps the extreme ends S2 and S3 of the wafer support portions 2a and 3a when viewed from the upper surface of the top plate 7, the abnormal gas disturbance on the central side of the wafer, which is caused by that the extreme ends S2 and S3 of the wafer support portions 2a and 3a project inward of the slit portion 7b, can be securely suppressed.

### Examples

When a vertical wafer boat of Figs. 1 to 4 was designed so that the extreme ends of wafer support portions 2a, 3a, 4a, and 5a did not project from an opening 7a and a slit portion 7b of a top plate 7 when viewed from above the top plate 7 by changing the length of wafer support portions 2a and 3a of support members 2 and 3 forward of a wafer insertion direction and the length of wafer support portions 4a, 5a of support members 4, 5 rearward of the wafer insertion direction and by changing the directions extending from support portions 2b, 3b, 4b, and 5b and the width of the slit portion 7b of the top plate 7, the parameters of the respective portions were shown by A, B, C, and D, respectively.
A: the ratio of a slit width to the width of a top plate;
B: the positions of the extreme ends of wafer support portions (a ratio from the center of a wafer to the radius of the wafer);
C: the chamfering positions of wafer support portions (the ratio of the length from the extreme ends of wafer support portions to the length of the wafer support portions); and
D: the angle of upper surface corners from the positions where the chamfering of the wafer support portions are ended to support columns. A comparative experiment was performed to vertical wafer boats made changing the conditions of the parameters A, B, C, and D as shown in Table 1 using a method described in the conditions of the comparative experiment.

The conditions of the comparative example will be described below.

A furnace used for the experiment is a φ300 mm vertical furnace which has a furnace inside diameter of φ390 mm and a furnace core tube height of 1650 mm and whose outside shape is formed such that top and bottom plate diameters of 330 mm and a boat height of 1200 mm. As the experiment using the furnace, after respective vertical wafer boats were continuously subjected to a heat treatment 10 times under the same use condition, one evaluation wafer was disposed at the center of the boat (at a fiftieth groove of a groove position from the upper portion of the boat) and was subjected to a heat treatment for evaluation.

The use condition is such that each vertical wafer boat on which 100 wafers were stacked at 600°C was put into the furnace, the temperature of the wafers was increased between 600°C and 1200°, and the wafers were taken out from the furnace after the temperature thereof was lowered to 600°C. Further, as an evaluation heat treatment, the evaluation wafer was put into the furnace at 600°C and the temperature of it was heated up to 1200°C and held for 10 hours, and thereafter the evaluation wafer was taken out from the furnace after the temperature thereof was lowered to 600°C. In any of the cases, the gas composed of a 100% argon gas was flown in the amount of 15 litters per minute.

MCL was evaluated using a 12-inch mirror-finished silicon wafer, and the MCL of the wafer was evaluated after the evaluation heat treatment. The MCL evaluation was performed to an iron element by an analysis of the ICP-MS method of JIS K 0102-57.4 Standard. A surface portion of 80% of the radius from a center toward an outer peripheral direction was classified as a portion 1, a surface portion outside of the portion 1 was classified as a portion 2, and a portion of the portion 1 added with the portion 2 was classified as a total portion, and the analyzed values of the respective portions were compared with each other. Note that the analysis method was based on the method disclosed in Japanese Patent Application Laid-Open Publication No. 2002-39927.

The determination index of the MCL evaluation was classified to three ranks depending on the values of the analysis result, and the MCL was evaluated by the three ranks. More specifically, a portion having an MCL value of 1.0 atoms/cc or more was evaluated as Δ, a portion in the range of 0.5 to 1.0 atoms/cc was evaluated as ○, and a portion having an MCL value which was less than 0.5 atoms/cc was evaluated as ⊚.

Further, a slip evaluation was performed in such a manner that 100 mirror-finished silicon wafers of 12 inches were stacked on a boat and subjected to a heat treatment once under the use condition described above, and the in-planes of three wafers, i.e., the in-planes of a first, fiftieth, and hundredth wafers from the upper portion of the boat were measured by X-ray topography and evaluated by being compared with the largest slip length which was longest in observed slips.

The determination index of the slip evaluation was classified to two ranks, and when a maximum slip length exceeding 30 mm existed, it was evaluated as Δ, and when a maximum slip length less than 10 mm existed or when a slip itself did not exist, it was evaluated as ○.

It was confirmed from the result of the evaluation by a comparative experiment of Table 1 that occurrence of slip of a wafer could be suppressed and the support portions were entirely purified by setting all the conditions A to D within the predetermined ranges of the present invention.

**[Table 1]**

| | Parameter (%) | | | | Result of MCL Evaluation | | | Slip Evaluation |
|---|---|---|---|---|---|---|---|---|
| | A | B | C | D | Portion 1 | Portion 2 | Total | |
| Comparative Example 1 | 30 | 55 | 65 | 90 | Δ | Δ | Δ | Δ |
| Example 1 | 35 | 60 | 60 | 90 | ○ | ○ | ○ | ○ |
| Example 2 | 40 | 65 | 50 | 90 | ○ | ⊚ | ⊚ | ○ |
| Example 3 | 45 | 75 | 40 | 85 | ○ | ○ | ○ | ○ |
| Comparative Example 2 | 50 | 80 | 35 | 90 | ○ | Δ | Δ | Δ |
| Conventional Example | 40 | 50 | 50 | 100 | Δ | Δ | Δ | ○ |

## Claims

1. A vertical wafer boat (1) having a top plate (7), a plurality of support columns (2b, 3b, 4b, 5b) each having one end fixed to the top plate and the other end fixed to a bottom plate (6), and wafer support portions (2a, 3a, 4a, 5a) projecting from side surfaces of the support columns in a horizontal direction,
wherein the top plate has an opening (7a) formed using the center point (O) of a wafer (W) to be mounted as its center and a slit portion (7b) communicating with the opening (7a) and formed to the insertion side of the wafer, and
wherein the slit has a width (T) which is 35% or more to 45% or less of the width (ΦD) of the top plate,
the vertical wafer boat **characterized in that**:
the wafer support portions (2a, 3a, 4a, 5a) extend to the position of 60% or more to 75% or less of the radius of the wafer (W) from the center (O) of the wafer to be mounted; and,
further, upper surface corners (2a1, 3a1, 4a1, 5a1) of the wafer support portions (2a, 3a, 4a, 5a) are chamfered up to the position of 40% or more to 60% or less of the length of the wafer support portions from the extreme ends of the
wafer support portions toward the direction of the support columns (2b, 3b, 4b, 5b) as well as the upper surface corners (2a2, 3a2, 4a2, 5a2) of the wafer support portions (2a, 3a, 4a, 5a) from the positions at which the chamfering is ended to the support columns are formed at an angle of 90° or less.

2. The vertical wafer boat according to claim 1, **characterized in that** the area of the opening (7a) of the top plate (7) is 30% or more to 40% or less of the area of upper surface of the top plate.

3. The vertical wafer boat according to claim 1 or 2, **characterized in that** the slit width (T) of the top plate (7) is the same as the interval between the extreme ends of the two wafer support portions (2a, 3a) positioned forward of a wafer insertion direction (X).

## Patentansprüche

1. Vertikales Waferboot (1), das eine obere Platte (7), eine Mehrzahl von Stützsäulen (2b, 3b, 4b, 5b), von denen jeweils ein Ende an der oberen Platte und das andere Ende an einer unteren Platte (6) befestigt ist, und Wafer-Stützbereiche (2a, 3a, 4a, 5a) aufweist, die von Seitenflächen der Stützsäulen in einer horizontalen Richtung vorstehen,
wobei die obere Platte eine Öffnung (7a), die unter Verwendung des Mittelpunkts (O) eines zu montierenden Wafers (W) als deren Mitte gebildet ist, und einen Schlitzbereich (7b) aufweist, der mit der Öffnung (7a) kommuniziert und zu der Einführungsseite des Wafers gebildet wird, und
wobei der Schlitz eine Breite (T) aufweist, die 35% oder mehr bis 45% oder weniger der Breite (ΦD) der oberen Platte ist,
wobei das vertikale Waferboot **dadurch gekennzeichnet ist, dass**:
sich die Wafer-Stützbereiche (2a, 3a, 4a, 5a) zu der Position von 60% oder mehr bis 75% oder weniger des Radius des Wafers (W) von der Mitte (O) des zu montierenden Wafers erstrecken; und
weiter, obere Flächenecken (2a1, 3a1, 4a1, 5a1) der Wafer-Stützbereiche (2a, 3a, 4a, 5a) bis zur Position von 40% oder mehr bis 60% oder weniger der Länge der Wafer-Stützbereiche von den äußersten Enden der Wafer-Stützbereiche zur Richtung der Stützsäulen (2b, 3b, 4b, 5b) hin abgeschrägt sind, und die oberen Flächenecken (2a2, 3a2, 4a2, 5a2) der Wafer-Stützbereiche (2a, 3a, 4a, 5a) von den Positionen, an welchen die Abschrägung endet, bis zu den Stützsäulen mit einem Winkel von 90° oder weniger gebildet werden.

2. Vertikales Waferboot nach Anspruch 1, **dadurch gekennzeichnet, dass** die Zone der Öffnung (7a) der oberen Platte (7) 30% oder mehr bis 40% oder weniger der Zone der oberen Fläche der oberen Platte ist.

3. Vertikales Waferboot nach Anspruch 1 oder 2, **dadurch gekennzeichnet, dass** die Schlitzbreite (T) der oberen Platte (7) die gleiche ist wie der Abstand zwischen den äußersten Enden der zwei Wafer-Stützbereiche (2a, 3a), die vorwärts von einer Wafer-Einführungsrichtung (X) angeordnet sind.

## Revendications

1. Nacelle de plaquettes verticale (1) ayant une plaque supérieure (7), une pluralité de colonnes de support (2b, 3b, 4b, 5b) ayant chacune une extrémité fixée à la plaque supérieure et l'autre extrémité fixée à une plaque inférieure (6), et des parties de support de plaquette (2a, 3a, 4a, 5a) faisant saillie à partir de surfaces latérales des colonnes de support selon une direction horizontale,
dans laquelle la plaque supérieure comporte une ouverture (7a) formée en utilisant le point central (O) d'une plaquette (W) destinée à être montée en tant que son centre et une partie fendue (7b) communiquant avec l'ouverture (7a) et formée sur le côté d'insertion de la plaquette, et
dans laquelle la fente présente une largeur (T) qui est égale ou supérieure à 35 % et égale ou inférieure à 45 % de la largeur (ΦD) de la plaque supérieure,
la nacelle de plaquettes verticale étant **caractérisée en ce que** :
les parties de support de plaquette (2a, 3a, 4a, 5a) s'étendent jusqu'à une position égale ou supérieure à 60 % et égale ou inférieure à 75 % du rayon de la plaquette (W) à partir du centre (O) de la plaquette à monter ; et,
en outre, des coins de surface supérieure (2a1, 3a1, 4a1, 5a1) des parties de support de plaquette (2a, 3a, 4a, 5a) sont chanfreinés jusqu'à une position égale ou supérieure à 40 % et égale ou inférieure à 60 % de la longueur des parties de support de plaquette depuis les extrémités extrêmes des parties de support de plaquette vers la direction des colonnes de support (2b, 3b, 4b, 5b), et de même les coins de surface supérieure (2a2, 3a2, 4a2, 5a2) des parties de support de plaquette (2a, 3a, 4a, 5a) à partir des positions dans lesquelles le chanfrein se termine vers les colonnes de support sont formées selon un angle égal ou inférieur à 90°.

2. Nacelle de plaquettes verticale selon la revendication 1, **caractérisée en ce que** l'aire de l'ouverture (7a) de la plaque supérieure (7) est égale ou supérieure à 30 % et égale ou inférieure à 40 % de l'aire de la surface supérieure de la plaque supérieure.

3. Nacelle de plaquettes verticale selon la revendication 1 ou 2, **caractérisée en ce que** la largeur de fente (T) de la plaque supérieure (7) est la même que l'intervalle entre les extrémités extrêmes des deux parties de support de plaquette (2a, 3a) positionnées en avant d'une direction d'insertion de plaquette (X).
